# EUROPEAN PATENT APPLICATION

(11) **EP 2 378 298 A1**
(43) Date of publication of application: **19.10.2011**
(21) Application number: 09829151.1
(22) Date of filing: 27.11.2009
(51) Int. Cl.: G01R 29/08

(54) **ELECTRIC FIELD MEASURING DEVICE**

(30) Priority: 27.11.2008 JP 2008303106
(71) Applicant: Sumitomo Osaka Cement Co., Ltd., Tokyo 102-8465 (JP)
(72) Inventor: MIYAZAKI Norikazu, Tokyo 102-8465 (JP); SAKAI Takeshi, Tokyo 102-8465 (JP)
(74) Representative: Staudt, Hans-Peter
(86) International application number: PCT/JP2009/070000
(87) International publication number: WO 2010/061906

(57) **Abstract**

The electric field measuring device measures an electric field intensity of an electromagnetic wave generated from equipment under test 8 in an area for detecting an electromagnetic wave. An antenna 1 and an optical intensity modulator having a Mach-Zehnder type optical waveguide are inside the area and an output signal of the antenna is supplied to a modulation electrode of the optical intensity modulator. A light source unit, a light receiving unit, and a DC bias control unit controlling a DC bias voltage supplied to the optical intensity modulator are outside the area. An optical wave is guided to the optical intensity modulator from the light source unit, and is guided to the light receiving unit from the optical intensity modulator via an optical fiber 4. The DC bias voltage is supplied to the optical intensity modulator from the DC bias control unit via a power supply line 4.

## Description

### Technical Field

The present invention relates to an electric field measuring device, and more particularly, to an electric field measuring device that measures an electric field intensity of an electromagnetic wave generated from equipment under test disposed in an area for detecting an electromagnetic wave, such as an anechoic room.

### Background Art

In various electrical and electronic apparatuses, it is necessary to restrict electromagnetic noise generated therefrom to a predetermined value or less. The purpose of this restriction is to suppress the erroneous operation of other electrical and electronic apparatuses or influence on body of the person handling the electrical and electronic apparatuses, which results from the electromagnetic noise.

In the field of EMC, with the recent increase in speed of electrical and electronic apparatuses and the recent spread of wireless LANs, EMC (electromagnetic compatibility) extending over a GHz band has become more important. Particularly, in emission (EMI: electromagnetic interference) measurement for measuring noise emitted from equipment under test, it is necessary to detect minute levels of noise emitted from the equipment under test in an area for detecting an electromagnetic wave, such as an anechoic room, by the use of an antenna and to transmit the detected noise to a measuring instrument.

In the past EMI measurement, the output signal from the antenna is transmitted via a transmission line composed of an RF pre-amplifier and a coaxial cable. However, for example, when the electromagnetic noise over a GHz band of 1 to 6 GHz is transmitted via a coaxial cable, most of the output signal is lost in the coaxial cable, thereby making it difficult to measure the output signal. Particularly, in the EMI measurement, the electromagnetic noise generated from the equipment under test originally has a low signal level and may thus be buried in the noise of a measuring instrument.

In consideration of the fact that a measuring space (the distance between the equipment under test and the antenna) in the detection area for detecting an electromagnetic wave, such as an anechoic room, is several m to several tens of m, it is necessary to guarantee several tens of m as the transmission distance from the antenna in the anechoic room (the detection area) to a measuring device outside the detection area. On the other hand, when an electrical signal over a GHz band is transmitted through a coaxial cable, the transmission distance is several m. Accordingly, it is necessary to reduce the distance between the reception antenna and the measuring device. In some cases, a part of the measuring device needs to be disposed in the area for detecting an electromagnetic wave, whereby the measurement reliability deteriorates and the measurement preparation is troublesome.

On the contrary, as described in Patent Citation 1, a technique of using an optical intensity modulator having a Mach-Zehnder type optical waveguide as an electric field sensor head has been proposed.

In general, when an optical intensity modulator is used as an electric field sensor head, a so-called bias-free optical intensity modulator to which a bias control voltage is not applied as described in Patent Citation 2 is used so as to avoid a situation in which an electrical signal, such as the bias control voltage applied to the optical intensity modulator, becomes a new source of noise generation.

### Citation List

### Patent Citation

Patent Citation 1: Specification of Japanese Patent No. 3404606
Patent Citation 2: Specification of Japanese Patent No. 3049190

However, in the bias-free optical intensity modulator, bias point adjustment precision deteriorates and the signal output level varies due to temperature variation of the test environment or a stress variation of fixing means of the optical intensity modulator, whereby the transmission characteristics of a detection signal deteriorate. There is a problem with a manufacturing yield of the optical intensity modulator and additional work such as operating point adjustment of individual elements is necessary, thereby making it difficult to reduce the cost. As described in Patent Citation 2, it is necessary to particularly add a mechanical structure adjusting a bias point to the bias-free optical intensity modulator, which makes it difficult to reduce the size of an electric field sensor head.

### Disclosure of Invention

### Technical Problem

A goal of the invention is to solve the above-mentioned problems and thus to provide an electric field measuring device which can permit highly-stable transmission and downsize an electric field sensor head.

### Technical Solution

In order to accomplish the above-mentioned goal, the invention according to claim 1 provides an electric field measuring device which measures an electric field intensity of an electromagnetic wave generated from equipment under test disposed in an area for detecting an electromagnetic wave, wherein an antenna and an optical intensity modulator having a Mach-Zehnder type optical waveguide are disposed inside the area and an output signal of the antenna is applied to a modulation electrode of the optical intensity modulator, wherein a light source unit, a light receiving unit, and a DC bias control unit controlling a DC bias voltage supplied to the optical intensity modulator on the basis of an optical intensity of output light of the optical intensity modulator are disposed outside the area, wherein an optical wave is guided to the optical intensity modulator from the light source unit via an optical fiber, wherein an optical wave is guided to the light receiving unit from the optical intensity modulator via an optical fiber, and wherein the DC bias voltage is supplied to the optical intensity modulator from the DC bias control unit via a power supply line.

The invention according to claim 2 provides the electric field measuring device according to claim 1, wherein the light source unit emits stationary light having a constant optical intensity and the DC bias control unit sets the DC bias voltage so that the average optical intensity of the output light is constant.

The invention according to claim 3 provides the electric field measuring device according to claim 1 or 2, wherein an amplifier that amplifies the output signal of the antenna is disposed inside the area and a DC voltage is supplied to the amplifier from a power supply circuit disposed outside the area via a power supply line.

The invention according to claim 4 provides the electric field measuring device according to any one of claims 1 to 3, wherein a low-pass filter for intercepting an AC signal is disposed in the power supply line.

The invention according to claim 5 provides the electric field measuring device according to any one of claims 1 to 4, wherein the optical intensity modulator is a reflective modulator in which an input portion and an output portion of optical waves are the same, an optical fiber guiding an optical wave to the optical intensity modulator from the light source unit and an optical fiber guiding an optical wave to the light receiving unit from the optical intensity modulator are the same optical fiber inside the area, and the optical wave input to the optical fiber from the light source unit and the optical wave output from the optical fiber to the light receiving unit are separated from each other by a circulator disposed outside the area.

### Advantageous Effects

In the invention according to claim 1, the antenna and the optical intensity modulator having a Mach-Zehnder type optical waveguide are disposed inside the area for detecting an electromagnetic wave and the output signal of the antenna is applied to the modulation electrode of the optical intensity modulator. The light source unit, the light receiving unit, and the DC bias control unit controlling the DC bias voltage supplied to the optical intensity modulator on the basis of an optical intensity of output light of the optical intensity modulator are disposed outside the area. The optical wave is guided to the optical intensity modulator from the light source unit via an optical fiber, an optical wave is guided to the light receiving unit from the optical intensity modulator via an optical fiber, and the DC bias voltage is supplied to the optical intensity modulator from the DC bias control unit via the power supply line. Accordingly, the bias point of the optical intensity modulator is always kept appropriate and the transmission characteristic is stabilized in spite of the temperature variation. In addition, since only the minimum necessary elements such as the body of the optical intensity modulator are disposed in the area for detecting an electromagnetic wave, the mechanical structure used in the past for adjusting a bias point becomes unnecessary, thereby downsizing the electric field sensor head. Since only the optical fiber or the power supply line for the DC bias voltage is connected to the antenna or the optical intensity modulator constituting the electric field sensor head and the light source unit, the light receiving unit, and the DC bias control unit are disposed outside the area for detecting an electromagnetic wave, it is possible to suppress the unnecessary noise emission in the area, thereby permitting highlyprecise measurement.

In the invention according to claim 2, the light source unit emits stationary light having a constant optical intensity and the DC bias control unit sets the DC bias voltage so that the average optical intensity of the output light is constant. Accordingly, AC signals such as a low-frequency signal widely used for the bias point control of the optical modulator at the time of controlling a bias point are unnecessary, whereby it is possible to further suppress the noise emission in the area for detecting an electromagnetic wave.

In the invention according to claim 3, the amplifier that amplifies the output signal of the antenna is disposed inside the area and a DC voltage is supplied to the amplifier from a power supply circuit disposed outside the area via a power supply line. Accordingly, since the signal intensity of the output signal of the antenna can be amplified and applied to the optical intensity modulator, it is possible to detect the electromagnetic noise from the equipment under test with higher precision. In addition, since only the DC voltage is applied to the amplifier, the amplifier does not serve as a source of the noise emission in the area for detecting an electromagnetic wave.

In the invention according to claim 4, the low-pass filter for intercepting an AC signal is disposed in the power supply line. Accordingly, it is possible to further suppress the AC signal serving as the source of the noise emission from being introduced into the area for detecting an electromagnetic wave, thereby providing an electric field measuring device with high reliability.

In the invention according to claim 5, the optical intensity modulator is a reflective modulator in which an input portion and an output portion of optical waves are the same, an optical fiber guiding an optical wave to the optical intensity modulator from the light source unit and an optical fiber guiding an optical wave to the light receiving unit from the optical intensity modulator are the same optical fiber inside the area for detecting an electromagnetic wave, and the optical wave input to the optical fiber from the light source unit and the optical wave output from the optical fiber to the light receiving unit are separated from each other by a circulator disposed outside the area. Accordingly, it is possible to reduce the burden of a work of connecting the optical fiber to the optical intensity modulator. In addition, since the number of optical fibers used in the area is one, it is possible to reduce the manufacturing cost.

### Brief Description of Drawings

Fig. 1 is a diagram schematically illustrating the configuration of an electric field measuring device according to the invention.
Fig. 2 is a diagram illustrating the detailed configurations of a head unit 2 and a body unit 6 in Fig. 1.

### Best Mode for Carrying out the Invention

Hereinafter, preferred embodiments of the invention will be described in detail.

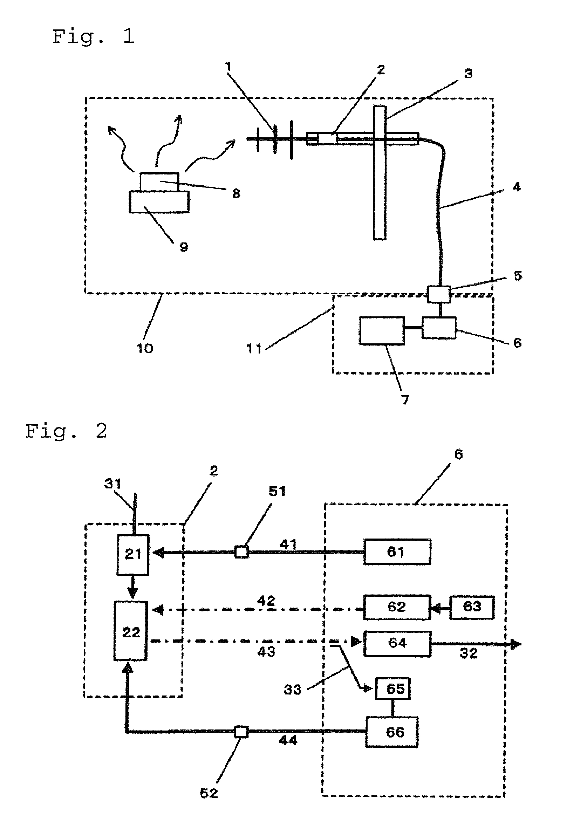

Fig. 1 is a diagram schematically illustrating the configuration of an electric field measuring device according to the invention. An electric field intensity of an electromagnetic wave (indicated by a broken arrow) generated from equipment under test (EUT) 8 disposed in an area for detecting an electromagnetic wave, such as an anechoic room 10, is measured. Reference numeral 9 represents a stage on which the equipment under test is placed such as a turn table.

The "area for detecting an electromagnetic wave" in the invention is not limited to the anechoic room, but refers to a space such as an open site in which the equipment under test is disposed to detect an electromagnetic wave generated from the equipment under test.
The outside of the "area for detecting an electromagnetic wave" means an area not interfering with the measurement of an electromagnetic wave generated from the equipment under test, and may include the outside of the anechoic room, a place sufficiently apart from the equipment under test, and a space such as a measuring room in which a body unit or a measuring instrument is received and which intercepts the leakage of an electromagnetic wave generated from the unit or instrument into the "area for detecting an electromagnetic wave".
Hereinafter, the anechoic room and the measuring room are exemplified.

An antenna 1 and a head unit 2 including an optical intensity modulator having a Mach-Zehnder type optical waveguide are disposed inside the anechoic room 10. The output signal of the antenna 1 is applied to a modulation electrode of the optical intensity modulator and changes the refractive index of the Mach-Zehnder type optical waveguide, as described in Patent Citation 1 or 2. With this change in refractive index, the phase of the optical wave propagating in the optical waveguide is modulated and the optical intensity of the optical wave output from the Mach-Zehnder type optical waveguide is modulated. Reference numeral 3 represents antenna positioning means for locating the antenna 1 at a predetermined position.

A traveling-wave type optical modulator in which an optical waveguide and a modulation electrode are formed in a substrate having an electro-optical effect can be suitably used as the optical intensity modulator. The substrate having an electro-optical effect is preferably formed of lithium niobate, lithium tantalate, PLZT (lead lanthanum zirconate titanate), quartz materials, or the like. The Mach-Zehnder type optical waveguide can be formed on the substrate having an electro-optical effect by diffusing Ti and the like on the substrate surface by the use of a thermal diffusion method or a proton exchange method or forming a ridge-shaped convex portion thereon. The modulation electrode includes a signal electrode or a ground electrode to which the output signal of the antenna is applied, and can be formed on the substrate by a method of forming Ti and Au electrode pattern or a gold plating method. A buffer layer of a dielectric of SiO2 may be formed on the substrate surface having the optical waveguide formed thereon, if necessary, thereby suppressing the absorption or scattering of an optical wave by the electrode formed on the optical waveguide.

In a method of adjusting a bias point of the optical intensity modulator, it is possible to adjust the bias point of the optical intensity modulator by applying a voltage, which is obtained by superposing a DC bias voltage on the output voltage of the antenna, to the modulation electrode. A bias-controlling electrode other than the modulation electrode may be separately formed and the DC bias voltage may be applied to the electrode.

A measuring room 11 is disposed adjacent to the anechoic room 10. A body unit 6 of the measuring device controlling the head unit 2 and a measuring instrument 7 such as an EMI receiver are disposed in the measuring room 11. The head unit 2 and the body unit 6 are connected to each other via a composite wire such as an optical fiber or a power supply line. Reference numeral 5 represents a low-pass filter for intercepting an AC signal, which is disposed in the power supply line and is configured so that the AC signal does not enter the anechoic room at the time of supplying the DC bias voltage to the head unit from the body unit 6.

Fig. 2 is a diagram illustrating the detailed configuration of the head unit 2 and the body unit 6.
An amplifier 21 receiving the output signal 31 from the antenna 1 and amplifying the received signal is disposed in the head unit 2. The output signal amplified by the amplifier 21 is supplied to the modulation electrode of the optical intensity modulator 22. Since the signal intensity of the output signal from the antenna can be raised and supplied to the optical intensity modulator, it is possible to detect the electromagnetic noise from the equipment under test with higher precision.

The amplifier 21 is supplied power from a power supply circuit 61 disposed in the body unit 6. The voltage applied to the amplifier 21 is a DC voltage and is supplied via the power supply line 41. In this way, since only the DC voltage is supplied, the generation of noise in the anechoic room is suppressed. Furthermore, to effectively suppress the generation of noise, a low-pass filter 51 is disposed in the power supply line 41 if necessary.

Stationary light emitted from a light source unit 62 such as a semiconductor laser is guided to the optical intensity modulator 22 by an optical fiber 42. Reference numeral 63 is a light source driving circuit driving the light source unit 62. The optical wave guided from the light source unit is modulated in intensity to correspond to the output signal of the antenna 1 by the optical intensity modulator, and is then guided to a light receiving unit 64 via an optical fiber 43. The light receiving unit 64 is a light receiving element such as a photodiode and outputs a detection signal 32 corresponding to the optical intensity of the output light of the optical intensity modulator.

The detection signal 32 is guided to the measuring instrument 7 shown in Fig. 1 and the level (intensity, frequency, and the like) of the noise emission from the equipment under test is detected therefrom.

In the electric field measuring device according to the invention, a bias control circuit is disposed in the body unit 6 so as to adjust the bias point of the optical intensity modulator 22. A part of the optical wave propagating through the optical fiber 43 is picked up, as referenced by reference numeral 33, using a photo-coupler or the like, and the output light of the optical intensity modulator is monitored by the use of a detector 65.

The output light of the optical intensity modulator is directly observed in Fig. 2, but radiation-mode light radiated from a merging section of the Mach-Zehnder type optical waveguide may also be used. In this case, it is necessary to dispose an optical fiber guiding the radiation-mode light to the detector 65 independently of the optical fiber referenced by reference numeral 43. A part of the output signal of the light receiving unit 64 may be used instead of the output signal of the detector 65.

The detection signal of the detector 65 is introduced into the DC bias control unit 66 and the DC bias voltage applied to the optical intensity modulator is adjusted so that the detection signal has a predetermined value (so that the output light of the optical intensity modulator has predetermined intensity). The DC bias voltage is applied via the power supply line 44 and the low-pass filter is disposed in the middle of power supply line if necessary, whereby the generation of noise in the anechoic room is suppressed.

Since the relational curve of driving voltage-optical intensity output (Vπ modulation curve) of the optical intensity modulator becomes a sine function, a half point of the maximum optical intensity is generally used as the center of the bias point adjustment. The center of the bias point adjustment is not limited to the half point, but an intensity level lower than the half point may be employed in balance with the shot noise of the light receiving unit 64.

If necessary, the bias point is adjusted before measuring an electric field. Specifically, an optical wave is guided to the optical intensity modulator from the light source unit 62, the bias voltage applied to the optical intensity modulator is swept out, the maximum value of the output level of monitor light is measured, and the bias voltage indicating a half value of the maximum value is found.

Since the bias point is adjusted in this way, the AC signal such as a low-frequency signal widely used in the bias point control of the past optical modulator is unnecessary, therefore further suppressing the noise emission in the anechoic room can be achieved.

When the optical intensity of the optical wave output from the light source unit varies, it is possible to adjust the bias point so as not to erroneously operate due to the variation of the light source unit in consideration of the variation in intensity as needed. When it is intended to use the optical wave from the light source unit as the monitor light, the photo-coupler may be disposed in the optical fiber 42. When the light source unit is a semiconductor laser, a back beam may be detected.

In this way, since only the minimum necessary elements such as the optical intensity modulator and the amplifier are disposed in the head unit 2 installed in the anechoic room, it is possible to downsize the head unit. Since the head unit 2 and the body unit 6 are connected to each other via only the optical fiber and the power supply line through which the DC voltage is supplied, it is possible to achieve long-distance and low-loss transmission, compared with the coaxial cable.

A typical Mach-Zehnder type optical waveguide including an input waveguide, two branch waveguides into which the input waveguide is branched, and an output optical waveguide into which the two branch waveguides are merged, has been described as the Mach-Zehnder type optical waveguide of the optical intensity modulator. However, the optical intensity modulator according to the invention may be a so-called "reflective modulator" in which reflecting means are disposed in the middles of two branch waveguides and an optical wave reflected therefrom travels in reverse and is output from the input waveguide again. When this reflective modulator is used, the number of optical fibers connecting the body unit and the head unit may be one. In this case, a circulator connected to the optical fiber may be disposed in the body unit so as to separate the optical wave input to the optical fiber from the light source unit and the optical wave output to the light receiving unit from the optical fiber from each other.

### Industrial Applicability

As described above, according to the invention, it is possible to provide an electric field measuring device which can permit highly-stable transmission and downsize an electric field sensor head.

### Explanation of References

- 1:: ANTENNA
- 2:: HEAD UNIT
- 4:: COMPOSITE WIRE (OPTICAL FIBER AND POWER SUPPLY LINE)
- 5, 51, 52:: LOW-PASS FILTER
- 6:: BODY UNIT
- 7:: MEASURING INSTRUMENT
- 8:: EQUIPMENT UNDER TEST
- 21:: AMPLIFIER
- 22:: OPTICAL INTENSITY MODULATOR
- 42, 43:: OPTICAL FIBER
- 61:: POWER SUPPLY CIRCUIT
- 62:: LIGHT SOURCE
- 63:: LIGHT SOURCE DRIVING CIRCUIT
- 64:: LIGHT RECEIVING UNIT
- 65:: DETECTOR
- 66:: DC BIAS CONTROL CIRCUIT

## Claims

1. An electric field measuring device which measures an electric field intensity of an electromagnetic wave generated from equipment under test disposed in an area for detecting an electromagnetic wave,
wherein an antenna and an optical intensity modulator having a Mach-Zehnder type optical waveguide are disposed inside the area and an output signal of the antenna is supplied to a modulation electrode of the optical intensity modulator,
wherein a light source unit, a light receiving unit, and a DC bias control unit controlling a DC bias voltage supplied to the optical intensity modulator on the basis of an optical intensity of output light of the optical intensity modulator are disposed outside the area,
wherein an optical wave is guided to the optical intensity modulator from the light source unit via an optical fiber,
wherein an optical wave is guided to the light receiving unit from the optical intensity modulator via an optical fiber, and
wherein the DC bias voltage is supplied to the optical intensity modulator from the DC bias control unit via a power supply line.

2. The electric field measuring device according to claim 1, wherein the light source unit emits stationary light having a constant optical intensity and the DC bias control unit sets the DC bias voltage so that the average optical intensity of the output light is constant.

3. The electric field measuring device according to claim 1 or 2, wherein an amplifier that amplifies the output signal of the antenna is disposed inside the area and a DC voltage is supplied to the amplifier from a power supply circuit disposed outside the area via a power supply line.

4. The electric field measuring device according to any one of claims 1 to 3, wherein a low-pass filter for intercepting an AC signal is disposed in the power supply line.

5. The electric field measuring device according to any one of claims 1 to 4, wherein the optical intensity modulator is a reflective modulator in which an input portion and an output portion of optical waves are the same, an optical fiber guiding an optical wave to the optical intensity modulator from the light source unit and an optical fiber guiding an optical wave to the light receiving unit from the optical intensity modulator are the same optical fiber inside the area, and the optical wave input to the optical fiber from the light source unit and the optical wave output from the optical fiber to the light receiving unit are separated from each other by a circulator disposed outside the area.
